(19) Europäisches Patentamt / European Patent Office / Office européen des brevets

(11) **EP 3 722 823 B1**

## (12) EUROPÄISCHE PATENTSCHRIFT

(45) Veröffentlichungstag und Bekanntmachung des Hinweises auf die Patenterteilung:
**07.06.2023   Patentblatt 2023/23**

(21) Anmeldenummer: **20168763.9**

(22) Anmeldetag: **08.04.2020**

(51) Internationale Patentklassifikation (IPC):
***G01R 31/389*** (2019.01)

(52) Gemeinsame Patentklassifikation (CPC):
**G01R 31/389;** G01R 31/392; Y02E 60/10

(54) **VERFAHREN ZUM BESTIMMEN EINES ALTERUNGSPARAMETERS, ZUSÄTZLICH EINES LADEZUSTANDSPARAMETERS UND EINER TEMPERATUR, EINES AKKUMULATORS, INSBESONDERE EINES LITHIUM-AKKUMULATORS**

METHOD FOR DETERMINING AN AGING PARAMETER, IN ADDITION A STATE OF CHARGE PARAMETER AND A TEMPERATURE, OF A BATTERY, IN PARTICULAR A LITHIUM BATTERY

PROCÉDÉ DE DÉTERMINATION D'UN PARAMÈTRE DE VIEILLISSEMENT, EN OUTRE D'UN PARAMÈTRE D'ÉTAT DE CHARGE ET D'UNE TEMPÉRATURE, D'UN ACCUMULATEUR, EN PARTICULIER D'UN ACCUMULATEUR LITHIUM

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **11.04.2019   DE 102019109622**

(43) Veröffentlichungstag der Anmeldung:
**14.10.2020   Patentblatt 2020/42**

(73) Patentinhaber: **Volkswagen AG**
**38440 Wolfsburg (DE)**

(72) Erfinder:
• **Seitz, Steffen**
**38176 Wendeburg (DE)**
• **Elster, Clemens**
**14195 Berlin (DE)**
• **Wübbeler, Gerd**
**12247 Berlin (DE)**
• **Füssler, Rainer**
**38112 Braunschweig (DE)**
• **Wünsch, Martin**
**38110 Braunschweig (DE)**

(74) Vertreter: **Gramm, Lins & Partner**
**Patent- und Rechtsanwälte PartGmbB**
**Frankfurter Straße 3 C**
**38122 Braunschweig (DE)**

(56) Entgegenhaltungen:
**WO-A2-2015/014764      DE-A1-102016 201 026**
**US-A1- 2003 184 307      US-B1- 10 180 460**

**Beschreibung**

Die Erfindung betrifft ein Verfahren zum Bestimmen eines Alterungsparameters eines Akkumulators.

Lithium-Akkumulatoren, insbesondere Lithium-Ionen-Akkumulatoren, finden zunehmend Verbreitung in Elektrofahrzeugen. Anders als bei Fahrzeugen, die von fossilen Energieträgern angetrieben werden, ist es bei Akkumulatoren schwierig, den genauen Energieinhalt zu bestimmen, der im Akkumulator vorhanden ist. Abhängig von dem Ladezustand ist die Reichweite des Fahrzeugs, was für den Benutzer eine sehr relevante Information darstellt.

Die Kapazität des Akkumulators, also die maximal speicherbare Menge an elektrischer Ladung, nimmt mit der Zeit und einer zunehmenden Anzahl an Be- und Entladezyklen ab. Die Geschwindigkeit, mit der die Kapazität abnimmt, hängt zudem von der Art ab, wie der Akkumulator be- und entladen wird. Es wäre daher wünschenswert, den momentanen Ladezustand sowie den momentanen Alterungszustand, also insbesondere die momentane Kapazität des Akkumulators, regelmäßig messen zu können.

Die Messung eines Alterungsparameters, der die Alterung des Akkumulators beschreibt, ist dadurch möglich, dass der Akkumulator zunächst zumindest annähernd vollständig entladen und danach vollständig geladen wird. Auf diese Weise kann die elektrische Arbeit bestimmt werden, die im Akkumulator gespeichert werden kann, also dessen Kapazität.

Die Alterung ist die Abnahme der Kapazität, die beispielsweise durch Be- und Entladen und/oder Lagern herbeigeführt werden kann. Der Alterungsparameter ist beispielsweise der Quotient aus der Nenn-Kapazität des Akkumulators und der momentanen Kapazität.

Nachteilig an diesem Vorgehen ist jedoch, dass der Akkumulator während der Zeit dieser Messung nicht zur Verfügung steht. In anderen Worten muss sichergestellt sein, dass der Akkumulator während dieser Zeit nicht benötigt wird, was jedoch problematisch ist. So ist für Benutzer eines Elektrofahrzeugs nicht tolerabel, dass das Fahrzeug für längere Zeit, beispielsweise zwei Tage, nicht zur Verfügung steht, da die Kapazität des Akkumulators gemessen werden muss.

Es ist daher versucht worden, mittels elektrochemischer Impedanzspektroskopie Aussagen über den momentanen Alterungszustand des Akkumulators zu treffen. Es hat sich jedoch herausgestellt, dass die bisherigen Ansätze nur eine geringe Aussagekraft haben.

Die US 2012 / 0 078 552 A1 beschreibt ein Verfahren zum Abschätzen des internen Zustands eines elektrochemischen Systems zur Speicherung elektrischer Energie, beispielsweise einer Batterie. Der SoC und die elektrochemische Impedanz werden für verschiedene interne Zustände eines elektrochemischen Systems des gleichen Typs wie das untersuchte elektrochemische System bestimmt. Ein elektrochemisches Impedanzmodell wird dann als Funktion des SoC und von Parametern definiert. Diese Parameter werden durch Einstellung der elektrochemischen Impedanzmessungen für die verschiedenen internen Zustände kalibriert. Die elektrochemische Impedanz Z des untersuchten Systems wird bestimmt und sein SoC wird unter Verwendung des auf die elektrochemische Impedanz Z angewendeten Modells geschätzt.

Aus der US 2013/0 069 660 A1 ist ein Verfahren zum Abschätzen des inneren Zustandes eines Systems zur elektrochemischen Speicherung elektrischer Energie, beispielsweise einer Batterie bekannt. Für verschiedene interne Zustände von Batterien des gleichen Typs wie eine zu analysierende Batterie werden Impedanzmessungen durchgeführt, indem dem durch die Batterien fließenden Strom ein elektrisches Signal hinzugefügt wird. Dann wird eine RC-Schaltung verwendet, um die Impedanzen zu modellieren. Als nächstes wird eine Verbindung zwischen dem SoC (und/oder dem SoH) und den Parametern der RC-Schaltung unter Verwendung einer multivariaten statistischen Analyse kalibriert. Eine Messung der Impedanz der zu analysierenden Batterie wird durchgeführt, die unter Verwendung der RC-Schaltung modelliert wird. Schließlich wird die Verbindung des für die zu analysierende Batterie definierten äquivalenten elektrischen Schaltkreises verwendet, um den internen Zustand dieser Batterie abzuschätzen.

Die US 2003/0184307 A1 beschreibt ein Verfahren zum Bestimmen eines Zustandsparameters einer elektrochemischen Zelle, bei dem Rohdaten mit einer Vielzahl von Vorhersagealgorithmen verarbeitet werden, die jeweils eine Zustandsparameterschätzung liefern. Aus diesen Ergebnissen wird der Zustandsparameter berechnet. Ein derartiges Verfahren ist vergleichsweise komplex und aufwändig.

Aus der DE 10 2016 201 026 A1 ist ein Verfahren bekannt, bei dem der Impedanzwert bei genau einer Frequenz ermittelt wird. Aus diesem Impedanzwert werden der Imaginärteil und der Phasenwinkel bestimmt. Aus diesen beiden Größen wird der Alterungszustand des Akkumulators abgeschätzt. Nachteilig an einem derartigen Verfahren ist, das sehr präzise Aussagen über den Alterungszustand nur schlecht möglich sind.

Die US 10 180 460 B1 beschreibt ein Verfahren zum Bestimmen des Alterungszustands, bei dem ein vorgegebenes elektrisches Signal an den Akkumulator angelegt wird. Es wird dann das Antwortsignal ermittelt, das sich aufgrund dieses Signals ergibt. Dieses Antwortsignal wird fouriertransformiert oder es wird die spektrale Dichte bestimmt.

In der WO 2015/014 764 A2 ist beschrieben, die elektrochemische Impedanzspektroskopie zur Diagnose von Akkumulatoren zu verwenden. Insbesondere wird vorgeschlagen, vordefinierte Einzelfrequenzen nacheinander zu verwenden. Anhand dieser Diagnose wird bestimmt, wie die Ladungszustände der einzelnen Speicherzellen des Akkumulators ausgeglichen werden sollen.

Der Erfindung liegt die Aufgabe zugrunde, Nachteile im Stand der Technik zu vermindern.

Die Erfindung löst das Problem durch ein Verfahren mit den Merkmalen von Anspruch 1.

Einsetzbar ist das Verfahren beispielsweise in einem Elektrofahrzeug, insbesondere einem Elektroauto, mit einem Akkumulator, insbesondere einem Lithium-Akkumulator, und einer Steuerung, die eingerichtet ist zum Durchführen eines erfindungsgemäßen Verfahrens. Dazu ist die Steuerung insbesondere ausgebildet zum automatischen Anlegen eines elektrischen Stroms mit verschiedenen Frequenzen f an den Akkumulator und zum Erfassen der zugehörigen Impedanz.

Im Rahmen der vorliegenden Beschreibung wird unter dem Alterungsparameters insbesondere ein Parameter verstanden, der angibt, wie hoch die Kapazität des Akkumulators zum momentanen Zeitpunkt ist. Insbesondere ist der Alterungsparameter gleich dem Quotient aus der Nenn-Kapazität des Akkumulators und der momentanen Kapazität.

Unter dem Ladezustandsparameter wird insbesondere ein Parameter verstanden, der kodiert, auf wieviel Prozent der momentanen Kapazität der Akkumulator geladen ist. Dies ist ein - meist in Amperestunden gemessener - Wert für die elektrische Ladung, die in dem Akkumulator gespeichert ist und die dem Akkumulator entnommen werden kann.

Unter der Temperatur T wird eine Temperatur verstanden, die in einer beliebigen Temperaturskala gemessen sein kann. Es ist möglich, nicht aber notwendig, dass es sich bei der Temperatur um die absolute Temperatur, eine Celsius-Temperatur oder eine Fahrenheit-Temperatur handelt. Insbesondere ist es möglich, dass sich die Temperatur T auf einen frei gewählten Nullpunkt bezieht, beispielsweise auf die ideale Betriebstemperatur des Akkumulators.

Unter der Impedanz Z des Akkumulators wird der komplexwertige elektrische Wechselstromwiderstand des Akkumulators verstanden. Die Impedanz wird insbesondere gemessen durch Angeben eines vorgegebenen Prüf-Stroms oder einer vorgegebenen Prüf-Spannung und durch Messen der jeweils resultierenden Spannung bzw. des resultierenden Stroms.

Es ist möglich, nicht aber notwendig, dass die Nyquist-Kurve und die Realteil-Kurve als Graphen dargestellt werden. Insbesondere ist es möglich, aus den gemessenen Werten der Impedanz Z in Abhängigkeit von der Frequenz f die angegebenen SOH-Parameter, SOC-Parameter und T-Parameter zu bestimmen.

Vorteilhaft an der Erfindung ist, dass der Alterungsparameter, der Ladezustandsparameter und/oder die Temperatur prozesssicher und vergleichsweise schnell bestimmt werden können. So ist es ausreichend, wenn 40 unterschiedliche Frequenzen zur Bestimmung der Impedanz Z verwendet werden. Vorzugsweise werden zumindest 8 unterschiedliche Frequenzen pro Frequenzdekade aufgenommen, also pro Intervall $[(n-1)*10 \text{ Hz}, ..., n*10 \text{ Hz}]$, wobei n eine natürliche Zahl ist. Der Frequenzbereich, in denen die Frequenzen liegen, erstreckt sich vorzugsweise von 10 mHz bis 1 kHz.

Es ist möglich und stellt eine bevorzugte Ausführungsform dar, dass erfasst wird, ob ein Elektrofahrzeug, in das der Akkumulator gemäß einer bevorzugten Ausführungsform eingebaut ist, außer Betrieb gesetzt wurde. Das kann beispielsweise dadurch geschehen, dass erfasst wird, dass ein Zündschlüssel gezogen wurde und/oder sich ein zur Freischaltung verwendetes Mobiltelefon aus dem Erfassungsbereich des Elektrofahrzeugs entfernt hat. Das erfindungsgemäße Verfahren wird dann selbsttätig durchgeführt, sodass der Alterungsparameter, der Ladezustandsparameter und/oder die Temperatur selbsttätig bestimmt werden.

Vorteilhaft ist zudem, dass durch die Einfachheit der verwendeten Parameter an einer Flotte von Elektrofahrzeugen der Verlauf des Alterungsparameters, des Ladezustandsparameters oder der Temperatur über die Zeit ausgewertet werden kann. Das ermöglich es, dass Alterungsverhalten des Akkumulators statisch auszuwerten und so die Entwicklung neuer Akkumulatoren zu verbessern.

Der erste Kurvenformparameter wird vorzugsweise durch Anpassen der Region um das lokale Minimum mittels einer Parabel bestimmt. Ein derartiges Anpassverfahren, das auch als Fit-Verfahren bekannt ist, ist aus dem Stand der Technik bekannt und wird daher nicht weiter erläutert.

Der dritte Kurvenformparameter wird vorzugsweise ebenfalls auf Basis eines Anpassens einer geraden, symmetrischen Modell-Funktion, insbesondere einer Parabel, bestimmt.

Der fünfte Kurvenformparameter wird vorzugsweise durch Anpassen mit einer Geraden ermittelt. Die Gerade erstreckt sich vorzugsweise in einem Linear-Bereich bei logarithmischer Darstellung der Frequenz, der sich von ca. 0,5 Hz bis circa 2 Hz erstreckt. Insbesondere erstreckt sich der Linear-Bereich in der Nähe eines Fußpunkts des Diffusionsastes nahe der Lokalminimums-Impedanz.

Bei der Bestimmung des sechsten SOH-Parameters $p_{SOH6}$ wird unter dem Merkmal, dass die Sensitivitäts-Frequenz benachbart zur Halbbogen-Maximumsfrequenz $f_{HbM}$ liegt, verstanden, dass sie im äußersten Quintil des Intervalls zwischen $f_{HbM}$ und der Lokal-Minimums-Frequenz $f_{LM}$ liegt. In Bezug auf den achten SOH-Parameter $p_{SOH8}$ wird unter dem Merkmal, dass sich der Betrag der Impedanz Z mit einer Alterung des Akkumulators streng monoton ändert, insbesondere verstanden, dass es sich um diejenige Frequenz handelt, für die sich der Betrag der Impedanz mit der Alterung am stärksten ändert. Die Diffusionscharakterisierungs-Frequenz $f_{diff}$ liegt vorzugsweise bei $10 \pm 3$ mHz.

Gemäß einer bevorzugten Ausführungsform wird als 11. SOH-Parameter $p_{SOH11}$ die Lokalminimums-Frequenz $f_{LM}$ bestimmt.

Unter dem Bilden der Zeilenvektoren, beispielsweise gemäß Schritt (e) von Anspruch 1, ist es möglich, nicht aber notwendig, dass dieser Zeilenvektor explizit als Vektor formuliert ist. Maßgeblich ist lediglich, dass die mathematische Operation, die durchgeführt wird, das gleiche Ergebnis liefert wie im Anspruch angegeben ist.

Wenn, wie gemäß der bevorzugten Ausführungsform vorgesehen, 11 SOH-Parameter verwendet werden, werden die Mischtherme selbstverständlich bis m = 11 berechnet.

Gemäß der Erfindung werden zumindest vier, vorzugsweise zumindest fünf, vorzugsweise zumindest sechs, vorzugsweise zumindest sieben, vorzugsweise zumindest acht, vorzugsweise zumindest neun, besonders bevorzugt zumindest zehn, der SOH-Parameter bestimmt.

Gemäß einer bevorzugten Ausführungsform werden genau vier, fünf sechs, sieben, acht, neun oder zehn, der SOH-Parameter bestimmt.

Gemäß einer bevorzugten Ausführungsform werden zumindest zwei, insbesondere zumindest drei, vorzugsweise zumindest vier, vorzugsweise zumindest fünf, vorzugsweise zumindest sechs, der SOC-Parameter bestimmt.

Gemäß einer bevorzugten Ausführungsform werden genau zwei, insbesondere genau drei, vorzugsweise genau vier, vorzugsweise genau fünf, vorzugsweise genau sechs, SOC-Parameter bestimmt.

Gemäß einer bevorzugten Ausführungsform werden zumindest zwei, insbesondere zumindest drei, vorzugsweise zumindest vier, der T-Parameter bestimmt.

Gemäß einer bevorzugten Ausführungsform werden genau zwei, insbesondere genau drei, vorzugsweise genau vier, der T-Parameter bestimmt.

Gemäß einer bevorzugten Ausführungsform des Verfahrens zum Bestimmen des Alterungsparameters $K_{SOH}$ wird der SOH-Kalibriervektor berechnet durch die folgenden Schritte:

($\alpha$) Bereitstellen eines neuen Akkumulators,
($\beta$) Messen des Alterungsparameters $K_{SOH,ist}$ bei Raumtemperatur und Messen der SOH-Parameter $p_{SOH,i}$, i= 1, ..., 11, bei Q unterschiedlichen Temperaturen und $M$ unterschiedlichen Ladezuständen , wobei der Alterungsparameter $K_{SOH,ist}$ eine Kapazität des Akkumulators bei Raumtemperatur ist, ($X$) Altern des Akkumulators um eine vorgegebene Alterung in Form einer Anzahl an Lade-und Entladezyklen oder in Form einer Lagerung über einen vorgegebenen Zeitraum, ($\delta$) N-1 maliges Wiederholen der Schritte ($\beta$) und ($\chi$), sodass $N \cdot M \cdot Q$ alterungsabhängige SOH-Parameter $p_{SOH,i}(r)$, r=1, ..., $N \cdot M \cdot Q$ mit jeweils zugehörigen Alterungsparametern $K_{SOH,ist}(r)$ erhalten werden, wobei entsprechend Schritt ($\beta$) der zugehörige Alterungsparameter $K_{SOH,ist}(r)$ für alle $M \cdot Q$ SOH-Parametern $p_{SOH,i}(r)$ eines Alterungsschritts den gleichen Wert hat, und ($\varepsilon$) Berechnen eines Kalibriervektors $\overrightarrow{A_{SOH}}$.

Unter dem Bereitstellen des neuen Akkumulators wird insbesondere verstanden, dass dessen Kapazität mindestens 99 % der Nenn-Kapazität beträgt. Die Nenn-Kapazität ist eine Eigenschaft des Akkumulators, die vom Hersteller angegeben wird.

Vorzugsweise umfasst das Berechnen des SOH-Kalibriervektors: ($\alpha$) Bilden eines SOH-Messwertvektors

$$\overrightarrow{M_{SOH,\text{ist}}} = \begin{pmatrix} K_{SOH,\text{ist}}(1) \\ K_{SOH,\text{ist}}(2) \\ \vdots \\ K_{SOH,\text{ist}}(N \cdot M \cdot Q - 1) \\ K_{SOH,\text{ist}}(N \cdot M \cdot Q) \end{pmatrix}$$

aus den alterungsabhängigen Alterungsparametern $K_{SOH,ist}(r)$, ($\beta$) Bil-

$$\boldsymbol{P}_{SOH,\text{ist}} = \begin{pmatrix} \vec{P}_{SOH,\text{ist}}(1) \\ \vec{P}_{SOH,\text{ist}}(2) \\ \vdots \\ \vec{P}_{SOH,\text{ist}}(N \cdot M \cdot Q) \end{pmatrix}$$

den einer SOH-Parametermatrix, in deren Zeilen die Zeilenvektoren $\vec{P}_{SOH,ist}(r)$, r=1,..., $N \cdot M \cdot Q$ stehen, die aus den SOH-Parametern und allen Mischtermen der Form $p_{SOH,m} \cdot p_{SOH,n}$, m= 1, ..., 11, n= 1, ..., m bestehen und ($X$) Berechnen des SOH-Kalibriervektors $\overrightarrow{A_{SOH}}$, der das Gleichungssystem $\overrightarrow{M_{SOH,\text{ist}}} = \boldsymbol{P}_{SOH,\text{ist}} \cdot \overrightarrow{A_{SOH}}$ optimal löst unter Beibehaltung nur der signifikanten Komponenten von $\overrightarrow{A_{SOH}}$, wobei die nicht signifikanten Komponenten Null gesetzt werden und die signifikanten Komponenten von $\overrightarrow{A_{SOH}}$ mittels schrittweiser Regression iterativ ermittelt werden.

Besonders günstig ist es, wenn zumindest alle SOH-Parameter bestimmt und danach die genannten Schritte durchgeführt werden. Nachfolgend ist es ausreichend, bei einem erneuten Durchführen des Verfahrens nur noch diejenigen SOH-Parameter zu verwenden, die nicht auf Null gesetzt wurden.

Unter dem Merkmal, dass die nicht signifikanten Komponenten Null gesetzt werden und die signifikanten Komponenten von $\overrightarrow{A_{SOH}}$ mittels schrittweiser Regression iterativ ermittelt werden, wird insbesondere verstanden, dass als Signifikanz-Kriterium der p-Wert einer F-Statistik verwendet wird, wobei gemäß einem Schritt (1) der p-Werte für jede Komponente eines Vektors $\overrightarrow{A_{SOH_l}}$ aus der Gleichung $\overrightarrow{M_{SOH}} = \boldsymbol{P}_{SOHi} \cdot \overrightarrow{A_{SOH_l}}$ berechnet wird, wobei die Indexerweiterung $i$ angibt, dass diese Größe iteriert wird, mit $\overrightarrow{A_{SOH_l}} = \overrightarrow{A_{SOH}}$ und $\overrightarrow{P_{SOHi}} = P_{SOH}$ im ersten Iterationsschritt. Falls nicht-signifikante Terme von $\overrightarrow{A_{SOC_i}}$ mit zugehörigen p-Werten oberhalb eines Schwellwertes von beispielsweise 0,1 existieren, wird das zum größten p-Wert zughörige Element $ea_{SOH}$ von $\overrightarrow{A_{SOH_l}}$ und die zugehörige Spalte $\overrightarrow{eP_{SOH}}$ von $\boldsymbol{P}_{SOHi}$ aus dem Gleichungssystem $\overrightarrow{M_{SOH}} = \boldsymbol{P}_{SOHi} \cdot \overrightarrow{A_{SOH_l}}$ eliminiert. Dadurch wird ein neuer Vektor $\overrightarrow{A_{SOH_l-}}$ und eine neue SOH-Parametermatrix $\boldsymbol{P}_{SOHi-}$ erhalten. Falls alle p-Werte unterhalb des Schwellwerts liegen, gilt $\overrightarrow{A_{SOH_l-}} = \overrightarrow{A_{SOH_l}}$ und $\boldsymbol{P}_{SOHi-}$ $= \boldsymbol{P}_{SOHi}$ (keine Änderung des Vektors bzw. der SOH-Parametermatrix).

Gemäß einem Schritt (2) wird, wenn eliminierte Komponenten $ea_{SOH,g}$ , g=1,..,G existieren (G Anzahl der eliminierten Komponenten), wie folgt geprüft, ob deren erneute Berücksichtigung zu einem signifikant besseren Fit des Gleichungssystems führt: Jeweils eine der eliminierten Komponente $ea_{SOH,g}$ und der jeweils zugehörigen Spaltenvektor $\overrightarrow{eP_{SOH,g}}$ wird wieder zu $\overrightarrow{A_{SOH_l-}}$ bzw. $\boldsymbol{P}_{SOHi-}$ hinzugefügt, wodurch man den Vektor $\overrightarrow{A_{SOH_l+}}$ und die SOH-Parametermatrix $\boldsymbol{P}_{SOHi+}$ erhält. Der p-Wert wird für jede Komponente des Vektors $\overrightarrow{A_{SOH_l+}}$ aus der Gleichung $\overrightarrow{M_{SOH}} = \boldsymbol{P}_{SOHi+} \cdot \overrightarrow{A_{SOH_l+}}$ berechnet. Falls p-Werte, die zu wieder hinzugefügten $ea_{SOH,g}$ gehören, unterhalb eines Schwellwertes von beispielsweise 0,05 existieren, wird die zum kleinsten p-Wert zugehörige Komponente $ea_{SOH,g}$ wieder zu $\overrightarrow{A_{SOH_l-}}$ und die entsprechende Spalte $\overrightarrow{eP_{SOH,g}}$ zu $\boldsymbol{P}_{SOHi-}$ hinzugefügt. Dadurch wird ein neuer Vektor $\overrightarrow{A_{SOH_l}}$ und eine neue SOH-Parametermatrix $\boldsymbol{P}_{SOCi}$ erhalten, mit denen die nächste Iteration durchgeführt wird. Falls alle zu $ea_{SOH,g}$ Komponenten gehörigen p-Werte oberhalb des Schwellwerts liegen, gilt $\overrightarrow{A_{SOH_l}} = \overrightarrow{A_{SOH_l-}}$ und $\boldsymbol{P}_{SOHi} = \boldsymbol{P}_{SOHi-}$ (keine Änderung des Vektors bzw. der SOH-Parametermatrix). Die Schritte (1) und (2) werden solange iteriert, bis keine Komponenten mehr eliminiert oder hinzugefügt werden.

In der SOH-Parametermatrix sind in Zahlen die Zeilenvektoren aus den Elementen $p_{SOH,i}$ und die entsprechenden Mischtermen enthalten. Es sei darauf hingewiesen, dass es möglich, nicht aber notwendig ist, dass die SOH-Parametermatrix in Matrixform erstellt wird. Maßgeblich ist lediglich, dass eine Berechnung durchgeführt, die der angegebenen Berechnung mittels der Matrix entspricht. Beispielsweise kann die Matrizengleichung auch als Summe über die entsprechenden Matrizenelemente dargestellt werden.

Das Berechnen des SOC-Kalibrierungsvektors umfasst vorzugsweise die in Anspruch 6 angegebenen Schritte. Dabei werden die Schritte des Bestimmens der SOC-Parameter und des Entladens des Akkumulators vorzugsweise zumindest 10 Mal durchgeführt, vorzugsweise zumindest 20 Mal durchgeführt. Je mehr Messpunkte aufgenommen werden, desto höher ist die später erreichbare Genauigkeit. Die iterative Regression wurde oben im Zusammenhang mit der Berechnung des SOH- Kalibriervektors beschrieben.

Das Berechnen des T-Kalibrierungsvektors umfasst vorzugsweise die in Anspruch 7 angegebenen Schritte. Dabei werden die Schritte des Bestimmens der T-Parameter und des Entladens des Akkumulators vorzugsweise zumindest 10 Mal durchgeführt, vorzugsweise zumindest 20 Mal durchgeführt. Je mehr Messpunkte aufgenommen werden, desto höher ist die später erreichbare Genauigkeit. Die iterative Regression wurde oben im Zusammenhang mit der Berechnung des T- Kalibriervektors beschrieben.

Im Folgenden wird die Erfindung anhand der beigefügten Zeichnungen näher erläutert. Dabei zeigt

Figur 1    eine schematische Ansicht eines Fahrzeugs,

Figur 2    eine Nyquist-Kurve eines Akkumulators des Fahrzeugs gemäß Figur 1 und

Figur 3    eine Realteil-Kurve, die einen Realteil der Impedanz Z gegen die Frequenz f aufträgt.

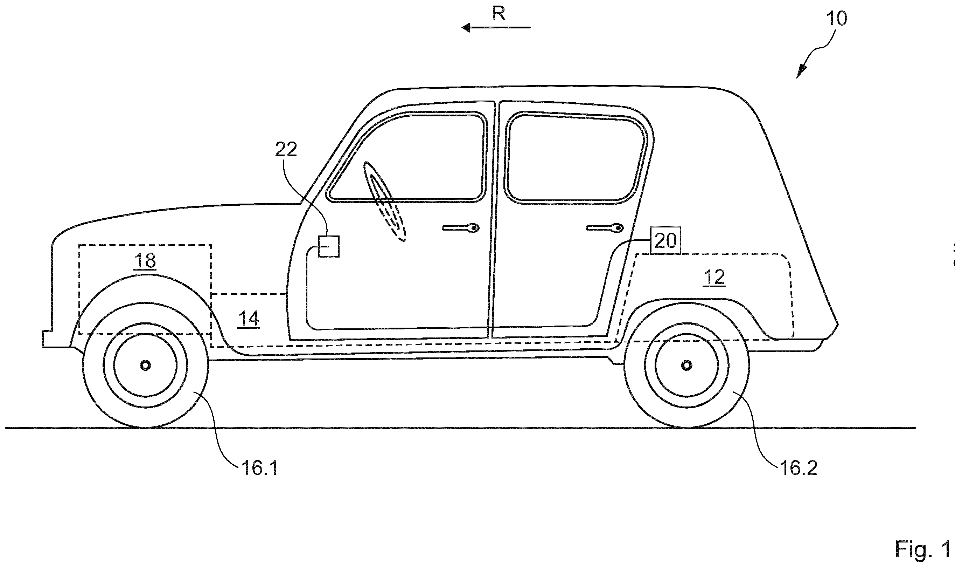

**Figur 1** zeigt ein Elektrofahrzeug 10 mit einem Akkumulator 12 zum Antreiben eines Motors 14, der Räder antreibt, von denen die Räder 16.1 und 16.2 zu sehen sind.

Es ist möglich, dass es sich bei dem Elektrofahrzeug 10 um ein Hybridfahrzeug handelt. In diesem Fall besitzt das Elektrofahrzeug 10 einen Verbrennungsmotor 18 zum Antreiben der Räder 16. Alternativ oder zusätzlich umfasst der Motor 18 einen elektrischen Generator zum Laden des Akkumulators 12. Es ist zudem möglich, dass der Motor 18 nicht zum direkten Antreiben der Räder ausgebildet ist, sondern zum Antreiben zumindest einen Elektromotors, der seinerseits die Räder 16 antreibt.

Das Elektrofahrzeug 10 umfasst eine Steuerung 20, die ausgebildet zum Bestromen des Motors 14 mit elektrischer Energie des Akkumulators 12. Die Steuerung 20 steht vorzugsweise in Verbindung mit einer Authentifizierungsvorrichtung 22, bei der es sich um ein Zündschloss oder um eine Kommunikationsvorrichtung zum Kommunizieren mit einem Mobiltelefon handeln kann. Im letzteren Fall ist die Kommunikationsvorrichtung ausgebildet zum Freigeben einer Bedienung des Motors 14 durch einen Benutzer des Elektrofahrzeugs 10 anhand eines Authentifizierungsschlüssels eines Mobiltelefons.

Erfasst die Steuerung 20, dass das Elektrofahrzeug 10 nicht benutzt wird, beispielswiese durch Erfassen, dass der Zündschlüssel gezogen wurde und/oder dass sich das zur Authentifizierung verwendete Mobiltelefon um mehr als eine vorgegebene Entfernung vom Elektrofahrzeug 10 entfernt hat, legt die Steuerung 20 einen elektrischen Strom mit einer Frequenz f an den Akkumulator 12 an und misst die Impedanz Z(f).

Das Messen der Impedanz Z umfasst vorzugsweise mehr als eine Periode der Wechselspannung. Nach dem Erreichen der Mindestzahl an Perioden des elektrischen Stroms legt die Steuerung 20 eine von der ersten Frequenz verschiedene zweite Frequenz an den Akkumulator 12 an. Auf diese Weise werden für eine Vielzahl von Frequenzen f die jeweils zugehörigen Impedanzen Z(f) erfasst.

Beispielsweise werden 8-10 Messfrequenzen pro Frequenzdekade aufgenommen. Diese werden auf einer logarithmischen Skala gleichmäßig verteilt. Vorzugsweise liegen im Bereich des Halbbogenmaximums zumindest fünf Frequenzen.

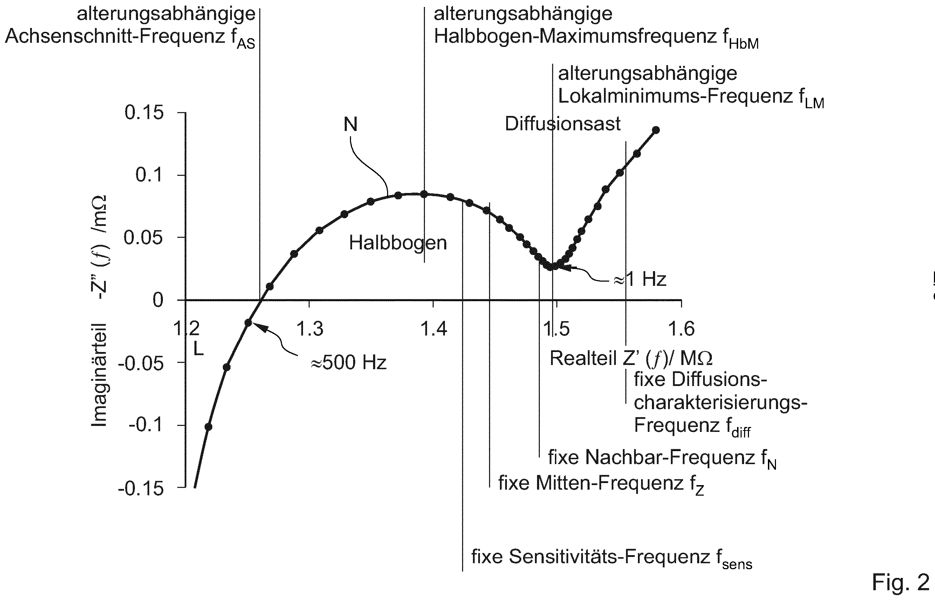

**Figur 2** zeigt eine Nyquist-Kurve, die aus den so gewonnenen Messdaten erhalten wird. Eingezeichnet sind eine Halbbogen-Maximumsfrequenz $f_{HbM}$, in der die Nyquist-Kurve N ein lokales Maximum durchläuft. Es ergibt sich zudem eine Lokalminimums-Frequenz $f_{LM}$, in der die Nyquist-Kurve N ein lokales Minimum durchläuft.

In einer Sensitivitäts-Frequenz $f_{sens}$ ändert sich mit einer zunehmenden Alterung der Betrag der Impedanz Z streng monoton. Die Sensitivitäts-Frequenz $f_{sens}$ beträgt beispielsweise ungefähr 10 Hz. Aus der Nyquist-Kurve ist zudem eine Diffusionscharakterisierungs-Frequenz $f_{diff}$ zu entnehmen.

In einer Achsschnitt-Frequenz $f_{AS}$ der Nyquist-Kurve N ist der Imaginärteil der Impedanz Z null. Es gilt also Im(Z) = 0. Die in Figur 2 oberhalb der Nyquist-Kurve N eingezeichneten Frequenzen hängen von der Alterung des Akkumulators ab, das heißt, dass sie sich mit zunehmender Alterung ändern. Die unten dargestellten Frequenzen hingegen sind fix, das heißt, dass sie nicht von der Alterung abhängig sind.

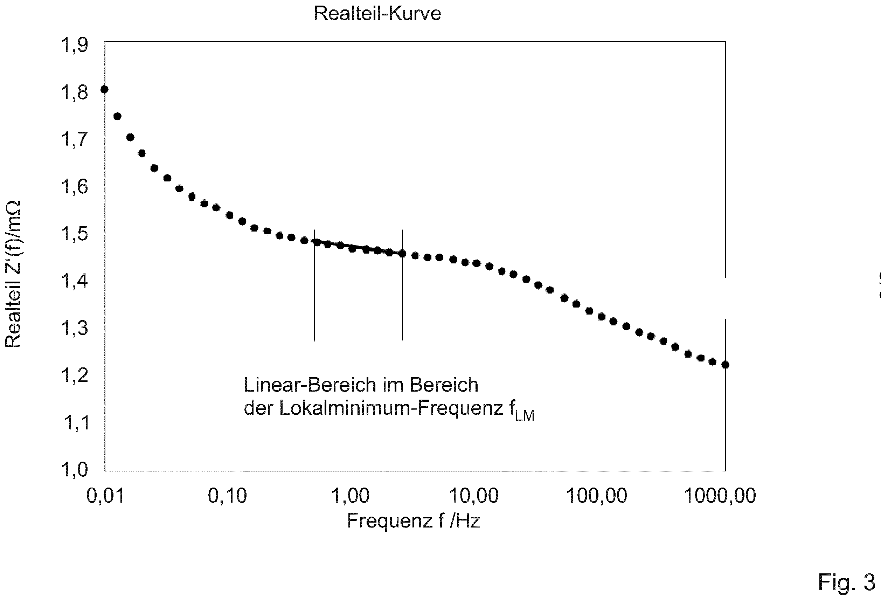

**Figur 3** zeigt eine Realteil-Kurve, in der die Realteile der Impedanzen Z(f) gegen eine logarithmische Darstellung der Frequenz f aufgetragen sind.

Nachdem die Steuerung 20 die Impedanzen Z(f) und damit die Nyquist-Kurve N aufgenommen hat, werden die folgenden SOH-Parameter $p_{SOHi}$ bestimmt:

(i) $p_{SOH1}$ = Re($Z_{HbM}$) = Re(Z(f)) mit f= $f_{HbM}$,
(ii) $p_{SOH2}$= Im($Z_{HbM}$),
(iii) psoH3 =Re($Z_{LM}$),
(iv) $p_{SOH4}$ = IM($Z_{LM}$),

(v) $p_{SOH5} = s = \dfrac{dZ(Re(Z))}{dlog(f)}\Big|_{f \in B}$ , wobei B der Linear-Bereich der Realteil-Kurve bei niedrigen Frequenzen f ist, der in **Figur 3** gezeigt ist, z.B. B = [0,5 Hz, ..., 2 Hz],

(vi) $p_{SOH6}$ = Re($Z_{sens}$) = Re(Z(f)) mit f = $f_{sens}$,
(vii) $p_{SOH7}$ = IM($Z_{sens}$),
(viii) $p_{SOH8}$ = Re($Z_{diff}$) = Re(Z(f) mit f= $f_{diff}$,
(ix) $p_{SOH9}$ = Im($Z_{diff}$),
(x) $p_{SOH10}$ = $f_{HbM}$,
(xi) $p_{SOH11}$ = $f_{LM}$.

Der Linear-Bereich B ist derjenige Abschnitt der Realteil-Kurve um die Lokal-Minimumfrequenz $f_{LM}$, in der die Realteil-Kurve in sehr guter Näherung linear approximierbar ist.

Zudem werden die folgenden SOC-Parameter bestimmt:

(i) $p_{SOC1}$ = $p_{SOH1}$,
(ii) $p_{SOC2}$ = $p_{SOH2}$,
(iii) $p_{SOC3}$ = $p_{SOH3}$,
(iv) $p_{SOC4}$ = Re($Z_{sens}$) = Re(Z($f_{sens}$)),
(v) $p_{SOC5}$ = Im ($Z_{sens}$),
(vi) $p_{SOC6}$ = $p_{SOC4}$ - Re($Z_N$), mit $Z_N$ = Z($f_N$), wobei $f_N$ eine Nachbar-Frequenz genannte Frequenz ist, die

größer ist als die Lokalminimums-Frequenz $f_{LM}$,
kleiner ist als eine Mitten-Frequenz fz und

von der Lokalminimums-Frequenz $f_{LM}$ sich um höchstens $(f_Z - f_{LM})/5$ unterscheidet,
wobei fz eine Mitten-Frequenz genannte Frequenz ist, die in einem zentralen Drittel zwischen der Halbbogen-Maximumsfrequenz $f_{HbM}$ und der Lokalminimums-Frequenz $f_{LM}$ liegt, und

(vii) $p_{SOC7}$: eine Phase $\varphi$ der Impedanz Zz = Z(f) bei f = fz.

Außerdem werden die folgenden T-Parameter $\tau$ bestimmt:

(i) $p_{T1} = p_{SOC4}$,
(ii) $p_{T2} = p_{SOC5}$,
(iii) $p_{T3} = P_{SOH8}$,
(iv) $p_{T4} = p_{SOH9}$ und
(v) $p_{T5} = T_{AS}$, wobei $T_{AS}$ eine Achsenschnitt-Frequenz genannte Frequenz ist, bei der der Imaginärteil der Impedanz null ist und die größer ist als die Halbbogen-Maximumsfrequenz ($f_{HbM}$).

Die Steuerung 12 berechnet den Alterungsparameter $K_{SOH}$ durch Bilden eines SOH-Zeilenvektors $\overrightarrow{P_{SOH}}$ aus den SOH-Parametern und allen Mischtermen der Form $p_{SOH,m} \cdot p_{SOH,n}$, m= 1, ..., 11, n= 1, ..., m und nachfolgendes Multiplizieren des SOH-Zeilenvektors $\overrightarrow{P_{SOH}}$ mit einem in der Steuerung 12 gespeicherten Kalibriervektor $\overrightarrow{A_{SOH}}$. Unterschreitet der Alterungsparameters $K_{SOH}$ einen vorgegebenen Soll-Alterungsparameter, wird eine Meldung ausgegeben, die dies kodiert.

Die Steuerung 12 berechnet zudem den Ladezustandsparameter Ksoc durch Bilden eines SOC-Zeilenvektors $\overrightarrow{P_{SOC}}$ aus den SOC-Parametern und allen Mischtermen der Form $p_{SOC,m} \cdot p_{SOC,n}$, m= 1, ..., 7, n= 1, ...,m und nachfolgendes Multiplizieren des SOC-Zeilenvektors $\overrightarrow{P_{SOC}}$ mit einem gespeicherten SOC-Kalibriervektor $\overrightarrow{A_{SOC}}$. Dieser Ladezustandsparameter Ksoc wird beispielsweise in einem Cockpit des Elektrofahrzeugs 10 angezeigt. Unterschreitet der Ladezustandsparameter Ksoc einen voreingestellten Mindest- Ladezustandsparameter, kann eine Meldung ausgegeben werden, die dies kodiert.

Die Steuerung 12 berechnet außerdem die Temperatur T des Akkumulators 12 durch Bilden eines T-Zeilenvektors $\overrightarrow{P_T}$ aus den T-Parametern und allen Mischtermen der Form $p_{T,m} \cdot p_{T,n}$, m= 1, ..., 5, n= 1, ..., m und nachfolgendes Multiplizieren des T-Zeilenvektors $\overrightarrow{P_T}$ mit einem gespeicherten Kalibriervektor $\overrightarrow{A_T}$. Überschreitet die Temperatur T einen voreingestellten Höchsttemperaturwert, kann eine Meldung ausgegeben werden, die dies kodiert. Alternativ oder zusätzlich wird die Leistung des Elektrofahrzeugs 10 gedrosselt.

## Bestimmung der Kalibriervektoren

Zum Bestimmen der Kalibriervektoren wird ein neuer Akkumulator 12 verwendet. Unter einem neuen Akkumulator wird ein Akkumulator verstanden, der höchstens 10 Lade-Entladezyklen durchlaufen hat und/oder eine Kapazität von zumindest 99% der Nenn-Kapazität hat.

An diesem Akkumulator werden der Alterungsparameter $K_{SOH}$, die SOH-Parameter $p_{SOHi}$, der Ladezustandsparameter Ksoc, die SOC-Parameter $p_{SOC,j}$, die Temperatur T und die T-Parameter $p_{Tk}$ bestimmt. Das erfolgt beispielsweise bei Raumtemperatur (23°C). Der Alterungsparameters $K_{SOH}$ ist beispielsweise die Kapazität in Amperestunden oder eine auf die Nenn-Kapazität bezogene relative Kapazität.

Danach wird ein Ladezustands SOC bei Raumtemperatur eingestellt, der durch den Ladezustandsparameter $K_{SOC,ist}$ quantifiziert wird. Der Akkumulator wird in anderen Worten ge- oder entladen. Die genannten Messgrößen werden erneut gemessen, sodass Messwerte erhalten werden. Diese Schritte werden für M Ladezustände durchgeführt. Beispielsweise werden die Ladezustandsparameter $K_{SOC,ist}$ 100%, 80%, 65%, 50%, 35% und 20% eingestellt.

Danach wird die Temperatur T des Akkumulators geändert und die genannten Messgrößen werden erneut gemessen. Diese Schritte werden für Q Temperaturen unterschiedliche durchgeführt, die durch gemessene Temperaturwerte $K_T$ quantifiziert werden. Diese Schritte können auch vor dem Ändern des Ladezustands durchgeführt werden.

Danach wird die Alterung des Akkumulators 12 dadurch verändert, dass der Akkumulator 12 mehrfach ganz oder teilweise ge- und entladen wird. Alternativ oder zusätzlich wird der Akkumulator bei einer Lagertemperatur, die um zumindest 20 Kelvin größer als die Raumtemperatur ist, gelagert und so gealtert. Nach jedem Alterungsschritt werden die Messgrößen, also der Alterungsparameter $K_{SOH}$, die SOH-Parameter $P_{SOHi}$, der Ladezustandsparameter Ksoc, die SOC-Parameter $p_{SOC,j}$, die Temperaturwerte $K_T$ und die T-Parameter $p_{Tk}$, aufgenommen.

Die Schritte des Einstellens des Ladezustände und der Temperaturen werden mehrfach für die jede Alterungsstufe wiederholt, sodass jeweils $N \cdot M \cdot Q$ Messwerte in Form der alterungs-, ladezustands- und temperaturabhängige SOH-Parameter $p_{SOH,i}$, SOC-Parameter $p_{SOC,j}$ und Temperaturparameter $p_{Tk}$ mit jeweils einem zugehörigen SOH-Parameter $K_{SOH,ist}$, einem zugehörigen SOC Parameter $K_{soc,ist}$ und einer zugehörigen Temperatur $K_{T,ist}$ erhalten werden.

$$\overrightarrow{M_{SOH,ist}} = \begin{pmatrix} K_{SOH,ist}(1) \\ K_{SOH,ist}(2) \\ \vdots \\ K_{SOH,ist}(N \cdot M \cdot Q - 1) \\ K_{SOH,ist}(N \cdot M \cdot Q) \end{pmatrix}$$

Danach wird ein SOH-Messwertvektors aus den alterungsabhängigen Alterungsparametern $K_{SOH,ist}(r)$, r=1,...,$N \cdot M \cdot Q$ und eine SOH-Parametermatrix

$$\boldsymbol{P}_{SOH,ist} = \begin{pmatrix} \vec{P}_{SOH,ist}(1) \\ \vec{P}_{SOH,ist}(2) \\ \vdots \\ \vec{P}_{SOH,ist}(N \cdot M \cdot Q) \end{pmatrix}$$ gebildet, in deren Zeilen die Zeilenvektoren $\vec{P}_{SOH,ist}(r)$, r=1,..., $N \cdot M \cdot Q$ stehen.

Die Zeilenvektoren enthalten die SOH-Parameter für eine Messung und alle Mischterme der Form $p_{SOH,m} \cdot p_{SOH,n}$, m= 1, ..., 11, n= 1, ..., m.

Danach wird derjenige Vektor berechnet, der das Gleichungssystem $\overrightarrow{M_{SOH,ist}} = \boldsymbol{P}_{SOH,ist} \cdot \overrightarrow{A_{SOH}}$ mit dem geringsten Fehler (Summe der Fehlerquadrate) löst. Das erfolgt mittels schrittweiser Regression, wie oben beschrieben ist. Der Lösungsvektor ist der SOH-Kalibriervektor $\overrightarrow{A_{SOH}}$.

Auf gleiche Weise werden der SOC-Kalibriervektor $\overrightarrow{A_{SOC}}$ und der Kalibriervektor $\overrightarrow{A_T}$ berechnet.

## Bezugszeichenliste

| | | | |
|---|---|---|---|
| 10 | Elektrofahrzeug | $f_{AS}$ | Achsenschnitt-Frequenz |
| 12 | Akkumulator | $f_{diff}$ | Diffusionscharakterisierungs-Frequenz |
| 14 | Motor | | |
| 16 | Rad | $f_{HbM}$ | Halbbogen-Maximusfrequenz |
| 18 | Verbrennungsmotor | $f_N$ | Nachbar-Frequenz |
| | | $f_{LM}$ | Lokalminimums-Frequenz |
| 20 | Steuerung | $f_{sens}$ | Sensitivitäts-Frequenz |
| 22 | Authentifizierungsvorrichtung | $f_Z$ | Mitten-Frequenz |
| | | g | Laufindex |
| $\varphi$ | Phase | G | Anzahl eliminierter Elemente im iterativen Regressionsverfahren |
| $\overrightarrow{A_{SOC}}$ | SOC Kalibriervektor | | |
| $\overrightarrow{A_{SOH}}$ | SOH Kalibriervektor | i | Laufindex |
| $\overrightarrow{A_T}$ | T Kalibriervektor | l | Iterationsindex |
| B | Linear-Bereich | $\square_{ist}$ | ist-Index, gibt an, dass ein Wert gemessen oder eingestellt wurde |
| easoc | im iterativen Regressionsverfahren aus $\overrightarrow{A_{SOC}}$ eliminiertes Element | | |
| | | j | Laufindex |
| | | k | Laufindex |
| $ea_{SOH}$ | im iterativen Regressionsverfahren aus $\overrightarrow{A_{SOH}}$ eliminiertes Element | $K_{SOC}$ | eingestellter SOC Wert |
| | | $K_{SOH}$ | gemessener SOH Wert |
| | | $K_T$ | gemessener T Wert |
| $ea_T$ | im iterativen Regressionsverfahren aus $\overrightarrow{A_T}$ eliminiertes Element | m | Laufindex |
| | | M | Zahl der Ladezustände |
| $\overrightarrow{eP_{SOC}}$ | im iterativen Regressionsverfahren aus $\boldsymbol{P}_{SOC}$ eliminierter Spaltenvektor $\overrightarrow{eP_{SOH}}$ im iterativen Regressionsverfahren aus $\boldsymbol{P}_{SOH}$ eliminierter Spaltenvektor | $\overrightarrow{M_{SOC}}$ | Vektor mit Ksoc Werten |
| | | $\overrightarrow{M_{SOH}}$ | Vektor mit $K_{SOH}$ Werten |
| | | $\overrightarrow{M_T}$ | Vektor mit $K_T$ Werten |
| | | N | Zahl der Alterungsschritte |

(fortgesetzt)

| $\overrightarrow{eP_T}$ | im iterativen Regressionsverfahren aus $\boldsymbol{P}_T$ eliminierter Spaltenvektor | $\boldsymbol{P}_{SOC}$ | Matrix mit gemessenen psoc Elementen |
|---|---|---|---|
| | | $\boldsymbol{P}_{SOH}$ | Matrix mit gemessenen $p_{SOH}$ Elementen |
| f | Frequenz | | |
| $\boldsymbol{P}_T$ | Matrix mit gemessenen $p_T$ Elementen | r | Laufindex |
| | | s | Steigung |
| $p_{SOC}$ | SOC-Parameter | SOC | Ladezustand |
| $P_{SOH}$ | SOH-Parameter | SOH | Alterungszustand |
| $p_T$ | T-Parameter | T | Temperatur |
| Q | Zahl der Temperaturen | Z | Impedanz |

**Patentansprüche**

1.  Verfahren zum Bestimmen eines Alterungsparameters $K_{SOH}$ eines Akkumulators (12) mit den Schritten:

    (a) Erfassen einer Impedanz Z des Akkumulators (12) bei verschiedenen Frequenzen f, sodass eine Nyquist-Kurve und ein Realteilverlauf, der einen Realteil der Impedanz Z gegen die Frequenz f aufträgt, erhalten werden,
    (b) Bestimmen von zumindest vier der folgenden SOH-Parameter:

    (i) einem ersten Kurvenformparameter ($p_{SOH1}$) in Form eines Realteils einer Halbbogen-Maximums-Impedanz ($Re(Z_{HbM})$) bei einer Halbbogen-Maximumsfrequenz ($f_{HbM}$), in der die Nyquist-Kurve ein lokales Maximum durchläuft,
    (ii) einem zweiten Kurvenformparameter ($p_{SOH2}$) in Form eines Imaginärteils der Halbbogen-Maximum-Impedanz ($Im(Z_{HbM})$),
    (iii) einem dritten Kurvenformparameter ($p_{SOH3}$) in Form eines Realteils einer Lokalminimums-Impedanz ($Re(Z_{LM})$) der Impedanz bei einer Lokalminimums-Frequenz $f_{LM}$, in der die Nyquist-Kurve ein Minimum zwischen der Halbbogen-Maximumsfrequenz $f_{HbM}$ und einem Diffusionsast durchläuft,
    (iv) einem vierten Kurvenformparameter ($p_{SOH4}$) in Form eines Imaginärteils der Lokalminimums-Impedanz ($Re(Z_{LM})$),
    (v) einem fünften Kurvenformparameter ($p_{SOH5}$) in Form einer Steigung s des Realteils der Impedanz in einem Linear-Bereich B des Realteilverlaufs,
    (vi) einem sechsten SOH-Parameter ($p_{SOH6}$) in Form eines Realteils der Impedanz Z bei einer Sensitivitäts-Frequenz $f_{sens}$, für die gilt, dass

    - die Sensitivitäts-Frequenz $f_{sens}$ kleiner ist als die Halbbogen-Maximumsfrequenz $f_{HbM}$,
    - benachbart zur Halbbogen-Maximumsfrequenz $f_{HbM}$ liegt und
    - sich mit zunehmender Alterung a der Betrag IZI der Impedanz Z bei einer Temperatur und einem Ladezustand streng monoton ändert,

    (vii) einem siebten SOH-Parameter ($p_{SOH7}$) in Form eines Imaginärteils der Impedanz Z bei der Sensitivitäts-Frequenz $f_{sens}$,
    (viii) einem achten SOH-Parameter ($p_{SOH8}$) in Form eines Realteils der Impedanz Z bei einer Diffusionscharakterisierungs-Frequenz $f_{diff}$, für die gilt, dass

    - die Diffusionscharakterisierungs-Frequenz $f_{diff}$ kleiner ist als die Lokalminimums-Frequenz $f_{LM}$ und
    - der Betrag IZI der Impedanz Z sich mit einer Alterung a des Akkumulators (12) bei einer Temperatur und einem Ladezustand streng monoton ändert,

    (ix) einem neunten SOH-Parameter ($p_{SOH9}$) in Form eines Imaginärteils der Impedanz Z bei der Diffusionscharakterisierungs-Frequenz $f_{diff}$,
    (x) einem zehnten SOH-Parameter ($p_{SOH10}$) in Form der Halbbogen-Maximumsfrequenz (fHbM) und
    (xi) einem elften SOH-Parameter ($p_{SOH11}$) in Form der Lokalminimums-Frequenz $f_{LM}$,

(c) Bilden eines SOH-Zeilenvektors $\overrightarrow{P_{SOH}}$ aus den SOH-Parametern und allen Mischtermen der Form $p_{SOH,m} \cdot p_{SOH,n}$, m= 1, ..., 11, n= 1, ..., m und

(d) Bilden des Skalarprodukts des SOH-Zeilenvektors $\overrightarrow{P_{SOH}}$ mit einem gespeicherten Kalibriervektor $\overrightarrow{A_{SOH}}$, sodass der Alterungsparameter $K_{SOH}$ erhalten wird.

2. Verfahren nach Anspruch 1, **dadurch gekennzeichnet, dass** zumindest fünf der SOH-Parameter bestimmt werden.

3. Verfahren nach einem der vorstehenden Ansprüche, **dadurch gekennzeichnet, dass** alle SOH-Parameter bestimmt werden.

4. Verfahren nach Anspruch 1, zudem zum Bestimmen eines Ladezustandsparameters Ksoc eines Akkumulators (12), mit den Schritten

(a) Erfassen einer Impedanz Z des Akkumulators (12) bei verschiedenen Frequenzen f, sodass eine Nyquist-Kurve erhalten wird,

(b) Bestimmen von zumindest einem der folgenden SOC-Parameter:

(i) einem ersten SOC-Parameter ($p_{SOC1}$) in Form des ersten Kurvenformparameters ($p_{SOH1}$),

(ii) einem zweiten SOC-Parameter ($p_{SOC2}$) in Form des zweiten Kurvenformparameters ($p_{SOH2}$),

(iii) einem dritten SOC-Parameter (psocs) in Form des dritten Kurvenformparameters ($p_{SOH3}$),

(iv) einem vierten SOC-Parameter ($p_{SOC4}$) in Form des Realteils der Impedanz bei der Sensitivitäts-Frequenz $f_{sens}$,

(v) einen fünften SOC-Parameter (psocs) in Form des Imaginärteils der Impedanz bei der Sensitivitäts-Frequenz $f_{sens}$,

(vi) einem sechsten SOC-Parameter (psocs) in Form einer Differenz aus

- dem vierten SOC-Parameter ($p_{SOC4}$) (=dem Realteil der Impedanz bei der Sensitivitäts-Frequenz $f_{sens}$) und

- dem Realteil der Impedanz bei einer fixen Nachbar-Frequenz $f_N$, die

größer ist als die Lokalminimums-Frequenz $f_{LM}$ bei ungealtertem Akkumulator und benachbart dazu liegt und
kleiner ist als die Mitten-Frequenz fz, und

(vii) einem siebten SOC-Parameter ($p_{SOC7}$) in Form einer Phase ($\varphi$) der Impedanz bei einer Mitten-Frequenz fz, die
in einem zentralen Drittel liegt zwischen der Halbbogen-Maximumsfrequenz $f_{HbM}$ und der Lokalminimums-Frequenz $f_{LM}$,

(c) Bilden eines SOC-Zeilenvektors $\overrightarrow{P_{SOC}}$ aus den SOC-Parametern und allen Mischtermen der Form $p_{SOC,m} \cdot p_{SOC,n}$, m= 1, ..., 7, n= 1, ...,m und

(d) Multiplizieren des SOC-Zeilenvektors $\overrightarrow{P_{SOC}}$ mit einem gespeicherten SOC-Kalibriervektor $\overrightarrow{A_{SOC}}$, sodass der Ladezustandsparameter Ksoc erhalten wird.

5. Verfahren nach Anspruch 4, **dadurch gekennzeichnet, dass** alle SOC-Parameter bestimmt werden.

6. Verfahren nach Anspruch 4, zudem zum Bestimmen einer Temperatur T eines Akkumulators (12) mit den Schritten:

(a) Erfassen einer Impedanz Z des Akkumulators bei verschiedenen Frequenzen f, sodass eine Nyquist-Kurve erhalten wird,

(b) Bestimmen von zumindest einem der folgenden T-Parameter:

(i) einem ersten T-Parameter ($p_{T1}$) in Form des vierten SOC-Parameters (psoc4),

(ii) einem zweiten T-Parameter ($p_{T2}$) in Form des fünften SOC-Parameters (psocs),

(iii) einem dritten T-Parameter ($p_{T3}$) in Form des achten SOH-Parameter ($p_{SOH8}$),

(iv) einem vierten T-Parameter ($p_{T4}$) in Form des neunten SOH-Parameter (psoH9) und

(v) einem fünften T-Parameter ($p_{T5}$) in Form einer Achsenschnitt-Frequenz (fAs),

- bei der der Imaginärteil der Impedanz Z null ist und
- die größer ist als die Halbbogen-Maximumsfrequenz ($f_{HbM}$),

(c) Bilden eines T-Zeilenvektors $\vec{P_T}$ aus den T-Parametern und allen Mischtermen der Form $p_{T,m} \cdot p_{T,n}$, m= 1, ..., 5, n= 1, ..., m und
(d) Multiplizieren des T-Zeilenvektors $\vec{P_T}$ mit einem gespeicherten Kalibriervektor $\vec{A_T}$ sodass die Temperatur T erhalten wird.

**7.** Verfahren nach Anspruch 6, **dadurch gekennzeichnet, dass** alle T-Parameter bestimmt werden.

**8.** Verfahren nach Anspruch 7, **dadurch gekennzeichnet, dass** das Berechnen von Kalibriervektoren $\overrightarrow{A_{SOH}}$, $\overrightarrow{A_{SOC}}$ und/oder $\vec{A_T}$ die folgenden Schritte umfasst:

(α) Bereitstellen eines neuen Akkumulators (12),
(β) Messen einer Kapazität $K_{SOH,ist}$ bei Raumtemperatur des Akkumulators (12),
(x) Einstellen eines Ladezustands SOC bei Raumtemperatur, der durch den Ladezustandsparameter Ksoc,ist quantifiziert wird,
(δ) Einstellen einer Temperatur des Akkumulators (12), die durch die Temperatur $K_T$ quantifiziert wird,
(ε) Bestimmen der SOH-Parameter $p_{SOH,ist,i}$ (i=1,...,11), der SOC-Parameter $p_{SOC,ist,j}$, j= 1, ...,7 und der Temperaturparameter $p_{T,k}$ mit k=1,...,5,
(φ) Wiederholen der Schritte (δ) und (ε) mit Q Temperaturen mit 4<Q<1000,
(γ) Wiederholen der Schritte (χ) bis (Φ), mit *M* Ladezuständen,
(η) Altern der Akkumulatoren,
(ι) (N-1)-faches Wiederholen der Schritte (β) bis (η) bis zu einer vorgegebenen Kapazität, sodass *N·M·Q* Messwerte in Form der alterungs-, ladezustands- und temperaturabhängige SOH-Parameter $p_{SOH,ist,i}$, SOC-Parameter $p_{SOC,ist,j}$ und T-Parameter $p_{T,k}$ mit jeweils einem zugehörigen Alterungsparameter $K_{SOH,ist}$, einem zugehörigen Ladezustandsparameter $K_{SOC,ist}$ und einer zugehörigen Temperatur $K_{T,ist}$ erhalten werden, und
(φ) Berechnen des SOH-Kalibriervektors $\overrightarrow{A_{SOH}}$, des SOC-Kalibriervektors $\overrightarrow{A_{SOC}}$ und des T-Kalibriervektors $\vec{A_T}$ aus den Messwerten.

**9.** Verfahren nach Anspruch 8, **dadurch gekennzeichnet, dass** das Berechnen des SOH-Kalibriervektors $\overrightarrow{A_{SOH}}$ die folgenden Schritte aufweist:

$$\overrightarrow{M_{SOH,ist}} = \begin{pmatrix} K_{SOH,ist}(1) \\ K_{SOH,ist}(2) \\ \vdots \\ K_{SOH,ist}(N \cdot M \cdot Q - 1) \\ K_{SOH,ist}(N \cdot M \cdot Q) \end{pmatrix}$$

(α) Bilden eines SOH-Messwertvektors aus den alterungsabhängigen Alterungsparametern $K_{SOH,ist}$ (r), r=1,...,$N \cdot M \cdot Q$,

$$\boldsymbol{P}_{SOH,ist} = \begin{pmatrix} \vec{P}_{SOH,ist}(1) \\ \vec{P}_{SOH,ist}(2) \\ \vdots \\ \vec{P}_{SOH,ist}(N \cdot M \cdot Q) \end{pmatrix},$$

(β) Bilden einer SOH-Parametermatrix
(χ) in deren Zeilen die Zeilenvektoren $\vec{P}_{SOH,ist}(r)$, r=1,..., $N \cdot M \cdot Q$ stehen, wobei der Zeilenvektor $\boldsymbol{P}_{SOH,ist}(r)$ aus den SOH-Parametern und allen Mischtermen der Form $p_{SOH,ist, m} \cdot p_{SOH,ist, n}$, m= 1, ..., 11, n= 1, ..., m gebildet ist, und
(δ) Berechnen des SOH-Kalibriervektors $\overrightarrow{A_{SOH}}$, der das Gleichungssystem $\overrightarrow{M_{SOH,ist}} = \boldsymbol{P}_{SOH,ist} \cdot \overrightarrow{A_{SOH}}$ optimal annähert unter Beibehaltung nur der signifikanten Komponenten von $\overrightarrow{A_{SOH}}$, wobei die nicht signifikanten Komponenten Null gesetzt werden und die signifikanten Komponenten von $\overrightarrow{A_{SOH}}$ mittels schrittweiser Regression iterativ ermittelt werden.

**10.** Verfahren nach Anspruch 8, **dadurch gekennzeichnet, dass** das Berechnen des SOC-Kalibriervektors $\overrightarrow{A_{SOC}}$ die folgenden Schritte aufweist:

$$\overrightarrow{M_{SOC,\text{ist}}} = \begin{pmatrix} K_{SOC,\text{ist}}(1) \\ K_{SOC,\text{ist}}(2) \\ \vdots \\ K_{SOC,\text{ist}}(N \cdot M \cdot Q - 1) \\ K_{SOC,\text{ist}}(N \cdot M \cdot Q) \end{pmatrix}$$

(α) Bilden eines SOC-Vektors aus den SOC-Parametern $K_{SOC,\text{ist}}$ (r), r=1,...,$N{\cdot}M{\cdot}Q$.

$$\boldsymbol{P}_{SOC,\text{ist}} = \begin{pmatrix} \vec{P}_{SOC,\text{ist}}(1) \\ \vec{P}_{SOC,\text{ist}}(2) \\ \vdots \\ \vec{P}_{SOC,\text{ist}}(N \cdot M \cdot Q) \end{pmatrix}$$

(β) Bilden einer SOC-Parametermatrix, in deren Zeilen die Zeilenvektoren $\vec{P}_{SOC,\text{ist}}(j)$ $j = 1, ...,N \cdot M \cdot Q$ stehen, wobei der Zeilenvektor $\vec{P}_{SOC,\text{ist}}(j)$ aus den SOC-Parametern und allen Mischtermen der Form $p_{SOC,\text{ist}, m} \cdot p_{SOC,\text{ist } n}$, gebildet ist,

(x) Berechnen des SOC-Kalibriervektors $\overrightarrow{A_{SOC}}$ der das Gleichungssystem $\overrightarrow{M_{SOC,\text{ist}}}$ = $\boldsymbol{P}_{SOC,\text{ist}} \cdot \overrightarrow{A_{SOC}}$ optimal annähert, unter Beibehaltung nur der signifikanten Komponenten von $\overrightarrow{A_{SOC}}$, wobei die nicht signifikanten Komponenten Null gesetzt werden und wobei die signifikanten Komponenten von $\overrightarrow{A_{SOC}}$ mittels schrittweiser Regression iterativ ermittelt werden.

**11.** Verfahren nach Anspruch 8, **dadurch gekennzeichnet, dass** das Berechnen des T-Kalibriervektors $\overrightarrow{A_T}$ die folgenden Schritte aufweist:

$$\overrightarrow{M_{T,\text{ist}}} = \begin{pmatrix} K_{T,ist}(1) \\ K_{T,ist}(2) \\ \vdots \\ K_{T,ist}(N \cdot M \cdot Q - 1) \\ K_{T,ist}(N \cdot M \cdot Q) \end{pmatrix}$$

(α) Bilden eines T-Vektors aus den Temperaturen $K_{T,ist}(r)$, r=1,...,$N{\cdot}M{\cdot}Q$.

$$\boldsymbol{P}_{T,ist} \begin{pmatrix} \vec{P}_{T,ist}(1) \\ \vec{P}_{T,ist}(2) \\ \vdots \\ \vec{P}_{T,ist}(N \cdot M \cdot Q) \end{pmatrix}$$

(β) Bilden einer T-Parametermatrix, in deren Zeilen die Zeilenvektoren $\vec{P}_{T,ist}(j)$, j=1,..., N · M · Q stehen, wobei der Zeilenvektor $\overrightarrow{P_{T,\text{ist}}}$ aus den T-Parametern und allen Mischtermen der Form $p_{T,ist,m} \cdot p_{T,ist,n}$, m= 1, ..., 5, n= 1, ..., m gebildet ist,

(x) Berechnen des T-Kalibriervektors $\overrightarrow{A_T}$,der das Gleichungssystem $\overrightarrow{M_T}$ = $\boldsymbol{P}_{T,ist} \cdot \overrightarrow{A_T}$ optimal annähert, unter Beibehaltung nur der signifikanten Komponenten von $\overrightarrow{A_T}$, wobei die nicht signifikanten Komponenten Null gesetzt werden und wobei die signifikanten Komponenten von $\overrightarrow{A_T}$ mittels schrittweiser Regression iterativ ermittelt werden.

**Claims**

**1.** A method for determining an ageing parameter $K_{SOH}$ of a rechargeable battery (12) comprising the steps:

(a) detecting an impedance Z of the rechargeable battery (12) at various frequencies f, so that a Nyquist plot and a real part curve, which plots a real part of the impedance Z against the frequency f, is obtained,

(b) determining at least four of the following SOH parameters:

(i) a first curve form parameter ($p_{SOH1}$) in the form of a real part of a semi-arc maximum impedance ($Re(Z_{HbM})$) at a semi-arc maximum frequency ($f_{HbM}$) in which the Nyquist plot passes a local maximum,

(ii) a second curve form parameter ($p_{SOH2}$) in the form of an imaginary part of the semi-arc maximum impedance ($Im(Z_{HbM})$),

(iii) a third curve form parameter ($p_{SOH3}$) in the form of a real part of a local minimum impedance ($Re(Z_{LM})$) of the impedance at a local minimum frequency $f_{LM}$, in which the Nyquist plot passes a minimum between the semi-arc maximum frequency $f_{HbM}$ and a diffusion branch,

(iv) a fourth curve form parameter ($p_{SOH4}$) in the form of an imaginary part of the local minimum impedance ($Re(Z_{LM})$),

(v) a fifth curve form parameter ($p_{SOH5}$) in the form of a slope s of the real part of the impedance in a linear range B of the real part curve,

(vi) a sixth SOH parameter ($p_{SOH6}$) in the form of a real part of the impedance Z at a sensitivity frequency $f_{sens}$ for which the following applies:

- the sensitivity frequency $f_{sens}$ is smaller than the semi-arc maximum frequency $f_{HbM}$,
- lies adjacent to the semi-arc maximum frequency $f_{HbM}$ and
- with increasing ageing a, the magnitude IZI of the impedance Z changes strictly monotonically at a temperature and charge level,

(vii) a seventh SOH parameter ($p_{SOH7}$) in the form of an imaginary part of the impedance Z at a sensitivity frequency $f_{sens}$,

(viii) an eighth SOH parameter ($p_{SOH8}$) in the form of a real part of the impedance Z at a diffusion characterisation frequency $f_{diff}$ for which the following applies:

- the diffusion characterisation frequency $f_{diff}$ is smaller than the local minimum frequency $f_{LM}$ and
- the magnitude IZI of the impedance Z changes strictly monotonically with increasing ageing a of the rechargeable battery (12) at a temperature and a charge level,

(ix) a ninth SOH parameter ($p_{SOH9}$) in the form of an imaginary part of the impedance Z at the diffusion characterisation frequency $f_{diff}$,

(x) a tenth SOH parameter ($p_{SOH10}$) in the form of the semi-arc maximum frequency (fHbM) and

(xi) an eleventh SOH parameter ($p_{SOH11}$) in the form of the local minimum frequency $f_{LM}$.

(c) forming an SOH row vector $\overrightarrow{P_{SOH}}$ from the SOH parameters and all mixed terms with the form $p_{SOH,m} \cdot p_{SOH,n}$, m= 1, ..., 11, n= 1, ..., m and

(d) forming the scalar product of the SOH row vector $\overrightarrow{P_{SOH}}$ with a stored calibration vector $\overrightarrow{A_{SOH}}$, thereby obtaining the ageing parameter $K_{SOH}$.

2. The method according to claim 1, **characterised in that** at least five of the SOH parameters are determined.

3. The method according to one of the preceding claims, **characterised in that** all SOH parameters are determined.

4. A method according to claim 1, also for determining a charge level parameter $K_{SOC}$ of a rechargeable battery (12) comprising the steps

(a) detecting an impedance Z of the rechargeable battery (12) at various frequencies f, so that a Nyquist plot is obtained,

(b) determining at least one of the following SOC parameters:

(i) a first SOC parameter ($p_{SOC1}$) in the form of the first curve form parameter ($p_{SOH1}$),

(ii) a second SOC parameter ($p_{SOC2}$) in the form of the second curve form parameter (psoH2),

(iii) a third SOC parameter (psocs) in the form of the third curve form parameter ($p_{SOH3}$),

(iv) a fourth SOC parameter ($p_{SOC4}$) in the form of the real part of the impedance at the sensitivity frequency $f_{sens}$,

(v) a fifth SOC parameter (psocs) in the form of the imaginary part of the impedance at the sensitivity frequency $f_{sens}$,

(vi) a sixth SOC parameter (psocs) in the form of a difference from

- the fourth SOC parameter ($p_{SOC4}$)(= the real part of the impedance at the sensitivity frequency $f_{sens}$) and
- the real part of the impedance at a fixed neighbouring frequency $f_N$, which

is greater than the local minimum frequency $f_{LM}$ with the unaged rechargeable battery and lies adjacent to it and
is smaller than the centre frequency fz, and

(vii) a seventh SOC parameter ($p_{SOC7}$) in the form of a phase (<p) of the impedance at a centre frequency fz, which
lies in a central third between the semi-arc maximum frequency $f_{HbM}$ and the local minimum frequency $f_{LM}$,

(c) forming an SOC row vector $\overrightarrow{P_{SOC}}$ from the SOC parameters and all mixed terms with the form $p_{SOH,m}·p_{SOH,n}$, m= 1, ..., 7, n= 1, ..., m and
(d) multiplying the SOC row vector $\overrightarrow{P_{SOC}}$ with a stored SOC calibration vector $\overrightarrow{A_{SOC}}$, , thereby obtaining the charge level parameter $K_{SOC}$.

5.  The method according to claim 4, **characterised in that** all SOC parameters are determined.

6.  The method according to claim 4 also for determining a temperature T of a rechargeable battery (12) comprising the steps:

(a) detecting an impedance Z of the rechargeable battery at various frequencies f, so that a Nyquist plot is obtained,
(b) determining at least one of the following T parameters:

(i) a first T parameter ($p_{T1}$) in the form of the fourth SOC parameter ($p_{SOC4}$),
(ii) a second T parameter ($p_{T2}$) in the form of the fifth SOC parameter (psocs),
(iii) a third T parameter ($p_{T3}$) in the form of the eighth SOH parameter ($p_{SOH8}$),
(iv) a fourth T parameter ($p_{T4}$) in the form of the ninth SOH parameter ($p_{SOH9}$) and
(v) a fifth T parameter ($p_{T5}$) in the form of an axial section frequency ($f_{AS}$),

- in which the imaginary part of the impedance Z is zero and
- is greater than the semi-arc maximum frequency ($f_{HbM}$),

(c) forming a T row vector $\overrightarrow{P_T}$ from the T parameters and all mixed terms with the form $p_{T,m}·p_{T,n}$, m= 1, ..., 5, n= 1, ..., m and
(d) multiplying the T row vector $\overrightarrow{P_T}$ with a stored calibration vector $\overrightarrow{A_T}$, thereby obtaining the temperature parameter T.

7.  The method according to claim 6, **characterised in that** all T parameters are determined.

8.  The method according to claim 7, **characterised in that** the calculation of calibration vectors $\overrightarrow{A_{SOH}}$, $\overrightarrow{A_{SOC}}$ and/or $\overrightarrow{A_T}$ comprises the following steps:

($\alpha$) providing a new rechargeable battery (12),
($\beta$) measuring a capacity $K_{SOH,ist}$ at room temperature of the rechargeable battery (12),
(x) setting a charge level SOC at room temperature, which is quantified by the charge level parameter Ksoc,ist,
($\delta$) setting a temperature of the rechargeable battery (12), which is quantified by the temperature $K_T$,
($\epsilon$) determining the SOH parameters $p_{SOH,ist,i}$ (i = 1,...,11), the SOC parameters $p_{SOC,ist,j}$, j= 1, ... 7 and the temperature parameters $p_{T,k}$ with k = 1,...,5,
) repeating the steps ($\delta$) and ($\epsilon$) with Q temperatures with 4 < Q < 1000,
($\gamma$) repeating the steps ($\chi$) to ($\Phi$) , with M charge levels,
($\eta$) ageing the rechargeable batteries,
(t) repeating steps ($\beta$) to ($\eta$) (N-1)-fold up to a predetermined capacity, so that $N·M·Q$ measured values in the form of the ageing-, charge level- and temperature-dependent SOH parameters $p_{SOH,ist,i}$, SOC parameters $p_{SOC,ist,j}$ and T parameters $p_{T,k}$ with, in each case, a respective ageing parameter $K_{SOH,ist}$, a respective charge level parameter $K_{SOC,ist}$ and a respective temperature $K_{T,ist}$ are obtained, and
($\varphi$) calculating the SOH calibration vector $\overrightarrow{A_{SOH}}$, the SOC calibration vector $\overrightarrow{A_{SOC}}$ and the T calibration vector $\overrightarrow{A_T}$ from the measured values.

9. The method according to claim 8, **characterised in that** the calculation of the SOH calibration vector $\overrightarrow{A_{SOH}}$ comprises the following steps:

($\alpha$) forming an SOH measured value vector $\overrightarrow{M_{SOH,ist}} = \begin{pmatrix} K_{SOH,ist}(1) \\ K_{SOH,ist}(2) \\ \vdots \\ K_{SOH,ist}(N \cdot M \cdot Q - 1) \\ K_{SOH,ist}(N \cdot M \cdot Q) \end{pmatrix}$ from the ageing-dependent ageing parameters $K_{SOH,ist}$ (r), r=1,... ,$N \cdot M \cdot Q$,

($\beta$) forming an SOH parameter matrix $\boldsymbol{P}_{SOH,ist} = \begin{pmatrix} \vec{P}_{SOH,ist}(1) \\ \vec{P}_{SOH,ist}(2) \\ \vdots \\ \vec{P}_{SOH,ist}(N \cdot M \cdot Q) \end{pmatrix}$,

($\chi$) the rows containing the row vectors $\vec{P}_{SOH,ist}(r)$, r=1,..., $N \cdot M \cdot Q$ , wherein the row vector $\vec{P}_{SOH,ist}(r)$ is formed from the SOH parameters and all mixed terms with the form $p_{SOH,ist,m} \cdot p_{SOH,ist, n}$, m= 1, ..., 11, n= 1, ..., m, and

($\delta$) calculating the SOH calibration vector $\overrightarrow{A_{SOH}}$ that optimally approximates the system of equations $\overrightarrow{M_{SOH,ist}}$ = $\boldsymbol{P}_{SOH,ist} \cdot \overrightarrow{A_{SOH}}$ while maintaining only the significant components of $\overrightarrow{A_{SOH}}$, wherein the non-significant components are set to zero and the significant components are determined iteratively $\overrightarrow{A_{SOH}}$ by means of stepwise regression.

10. The method according to claim 8, **characterised in that** the calculation of the SOC calibration vector $\overrightarrow{A_{SOC}}$ comprises the following steps:

($\alpha$) forming an SOC vector $\overrightarrow{M_{SOC,ist}} = \begin{pmatrix} K_{SOC,ist}(1) \\ K_{SOC,ist}(2) \\ \vdots \\ K_{SOC,ist}(N \cdot M \cdot Q - 1) \\ K_{SOC,ist}(N \cdot M \cdot Q) \end{pmatrix}$ from the SOC parameters $K_{SOH,ist}(r)$, r=1,...,$N \cdot M \cdot Q$,

($\beta$) forming an SOC parameter matrix, $\boldsymbol{P}_{SOC,ist} = \begin{pmatrix} \vec{P}_{SOC,ist}(1) \\ \vec{P}_{SOC,ist}(2) \\ \vdots \\ \vec{P}_{SOC,ist}(N \cdot M \cdot Q) \end{pmatrix}$ the rows of which contain the row vectors $\vec{P}_{SOC,ist}(j)$, j = 1,...,$N \cdot M \cdot Q$, wherein the row vector $\vec{P}_{SOC,ist}(j)$ is formed from the SOC parameters and all mixed terms with the form $p_{SOC,ist, m} \cdot p_{SOC,ist\ n}$,

($\chi$) calculating the SOC calibration vector $\overrightarrow{A_{SOC}}$ that optimally approximates the system of equations $\overrightarrow{M_{SOC,ist}}$ = $\boldsymbol{P}_{SOC,ist} \cdot \overrightarrow{A_{SOC}}$ while maintaining only the significant components of $\overrightarrow{A_{SOC}}$, wherein the non-significant components are set to zero and the significant components of $\overrightarrow{A_{SOC}}$ are iteratively determined by means of stepwise regression.

11. The method according to claim 8, **characterised in that** the calculation of the T calibration vector $\overrightarrow{A_T}$ comprises the following steps:

$$\overrightarrow{M_{T,ist}} = \begin{pmatrix} K_{T,ist}(1) \\ K_{T,ist}(2) \\ \vdots \\ K_{T,ist}(N \cdot M \cdot Q - 1) \\ K_{T,ist}(N \cdot M \cdot Q) \end{pmatrix}$$

(α) forming a T vector from the temperatures $K_{T,ist}(r)$, r=1,...,$N \cdot M \cdot Q$.

$$\boldsymbol{P}_{T,ist} \begin{pmatrix} \vec{P}_{T,ist}(1) \\ \vec{P}_{T,ist}(2) \\ \vdots \\ \vec{P}_{T,ist}(N \cdot M \cdot Q) \end{pmatrix}$$

(β) forming a T parameter matrix , the rows containing the row vectors $\vec{P}_{T,ist}(j)$, j=1,..., $N \cdot M \cdot Q$ , wherein the row vector $\overrightarrow{P_{T,ist}}$ is formed from the T parameters and all mixed terms with the form $p_{T,ist,m} \cdot p_{T,ist,n}$, m= 1, ..., 5, n= 1, ..., m,

(χ) calculating the T calibration vector $\overrightarrow{A_T}$ that optimally approximates the system of equations $\overrightarrow{M_T} = \boldsymbol{P}_{T,ist} \cdot \overrightarrow{A_T}$ while maintaining only the significant components of $\overrightarrow{A_T}$, wherein the non-significant components are set to zero and the significant components are determined iteratively $\overrightarrow{A_T}$ by means of stepwise regression.

## Revendications

1. Procédé de détermination d'un paramètre de vieillissement $K_{SOH}$ d'un accumulateur (12), comprenant les étapes suivantes consistant à :

(a) détecter une impédance Z de l'accumulateur (12) à différentes fréquences f, de manière à obtenir une courbe de Nyquist et un profil de la partie réelle, qui trace une partie réelle de l'impédance Z en fonction de la fréquence f,
(b) déterminer au moins quatre des paramètres SOH suivants :

(i) un premier paramètre de forme d'onde ($p_{SOH1}$) sous la forme d'une partie réelle d'une impédance de maximum en demi-arc ($Re(Z_{HbM})$) à une fréquence de maximum en demi-arc ($f_{HbM}$), dans laquelle la courbe de Nyquist passe par un maximum local,
(ii) un deuxième paramètre de forme d'onde ($p_{SOH2}$) sous la forme d'une partie imaginaire de l'impédance de maximum en demi-arc ($Im(Z_{HbM})$),
(iii) un troisième paramètre de forme d'onde ($p_{SOH3}$) sous la forme d'une partie réelle d'une impédance de minimum local ($Re(Z_{LM})$) de l'impédance à une fréquence de minimum local $f_{LM}$, dans laquelle la courbe de Nyquist passe par un minimum entre la fréquence de maximum en demi-arc $f_{HbM}$ et une branche de diffusion,
(iv) un quatrième paramètre de forme d'onde ($p_{SOH4}$) sous la forme d'une partie imaginaire de l'impédance de minimum local ($Re(Z_{LM})$),
(v) un cinquième paramètre de forme d'onde ($p_{SOH5}$) sous la forme d'une pente s de la partie réelle de l'impédance dans une zone linéaire B du profil de la partie réelle,
(vi) un sixième paramètre SOH ($p_{SOH6}$) sous la forme d'une partie réelle de l'impédance Z à une fréquence de sensibilité $f_{sens}$, sachant que

- la fréquence de sensibilité $f_{sens}$ est inférieure à la fréquence de maximum en demi-arc $f_{HbM}$,
- est voisine de la fréquence de maximum en demi-arc $f_{HbM}$ et
- avec un vieillissement croissant a, la valeur absolue |Z| de l'impédance Z à une température et dans un état de charge varie de manière strictement monotone,

(vii) un septième paramètre SOH ($p_{SOH7}$) sous la forme d'une partie imaginaire de l'impédance Z à la fréquence de sensibilité $f_{sens}$,
(viii) un huitième paramètre SOH ($p_{SOH8}$) sous la forme d'une partie réelle de l'impédance Z à une fréquence de caractérisation de la diffusion $f_{diff}$, sachant que

- la fréquence de caractérisation de la diffusion $f_{diff}$ est inférieure à la fréquence de minimum local $f_{LM}$,

et que

- la valeur absolue |Z| de l'impédance Z varie de manière strictement monotone avec un vieillissement a de l'accumulateur (12) à une température et dans un état de charge,

(ix) un neuvième paramètre SOH ($p_{SOH9}$) sous la forme d'une partie imaginaire de l'impédance Z à la fréquence de caractérisation de la diffusion $f_{diff}$,

(x) un dixième paramètre SOH ($p_{SOH10}$) sous la forme de la fréquence de maximum en demi-arc ($f_{HbM}$), et

(xi) un onzième paramètre SOH ($p_{SOH11}$) sous la forme de la fréquence de minimum local $f_{LM}$,

(c) former un vecteur ligne SOH $\overrightarrow{P_{SOH}}$ à partir des paramètres SOH et de tous les termes mixtes de la forme $p_{SOH,m} \cdot p_{SOH,n}$ , m=1, ..., 11, n=1, ..., m, et

(d) former le produit scalaire du vecteur ligne SOH $\overrightarrow{P_{SOH}}$ par un vecteur d'étalonnage stocké $\overrightarrow{A_{SOH}}$, de manière à obtenir le paramètre de vieillissement $K_{SOH}$.

2. Procédé selon la revendication 1,
   **caractérisé en ce que** l'on détermine au moins cinq des paramètres SOH.

3. Procédé selon l'une des revendications précédentes,
   **caractérisé en ce que** l'on détermine tous les paramètres SOH.

4. Procédé selon la revendication 1 pour déterminer un paramètre d'état de charge $K_{SOC}$ d'un accumulateur (12), comprenant les étapes consistant à :

   (a) détecter une impédance Z de l'accumulateur (12) à différentes fréquences f, de manière à obtenir une courbe de Nyquist,

   (b) déterminer au moins un des paramètres SOC suivants :

   (i) un premier paramètre SOC ($p_{SOC1}$) sous la forme du premier paramètre de forme d'onde ($p_{SOH1}$),

   (ii) un deuxième paramètre SOC ($p_{SOC2}$) sous la forme du deuxième paramètre de forme d'onde ($p_{SOH2}$),

   (iii) un troisième paramètre SOC ($p_{SOC3}$) sous la forme du troisième paramètre de forme d'onde (psoHs),

   (iv) un quatrième paramètre SOC ($p_{SOC4}$) sous la forme de la partie réelle de l'impédance à la fréquence de sensibilité $f_{sens}$,

   (v) un cinquième paramètre SOC (psocs) sous la forme de la partie imaginaire de l'impédance à la fréquence de sensibilité $f_{sens}$,

   (vi) un sixième paramètre SOC (psocs) sous la forme d'une différence

   - du quatrième paramètre SOC ($p_{SOC4}$) (= la partie réelle de l'impédance à la fréquence de sensibilité $f_{sens}$) et
   - de la partie réelle de l'impédance à une fréquence voisine fixe $f_N$, qui

   est supérieure à la fréquence de minimum local $f_{LM}$ lorsque l'accumulateur n'a pas vieilli, et
   est voisine de celle-ci et
   est inférieure à la fréquence centrale fz, et

   (vii) un septième paramètre SOC ($p_{SOC7}$) sous la forme d'une phase (cp) de l'impédance à une fréquence centrale fz qui se situe dans un tiers central entre la fréquence de maximum en demi-arc $f_{HbM}$ et la fréquence de minimum local $f_{LM}$,

   (c) former un vecteur ligne SOC $\overrightarrow{P_{SOC}}$ à partir des paramètres SOC et de tous les termes mixtes de la forme $p_{SOC,m} \cdot p_{SOC,n}$ , m=1, ..., 7, n=1, ..., m, et

   (d) multiplier le vecteur ligne SOC $\overrightarrow{P_{SOC}}$ par un vecteur d'étalonnage SOC stocké $\overrightarrow{A_{SOC}}$, de manière à obtenir le paramètre d'état de charge $K_{SOC}$.

5. Procédé selon la revendication 4,
   **caractérisé en ce que** l'on détermine tous les paramètres SOC.

**6.** Procédé selon la revendication 4 pour déterminer une température T d'un accumulateur (12), comprenant les étapes consistant à :

(a) détecter une impédance Z de l'accumulateur à différentes fréquences f, de manière à obtenir une courbe de Nyquist,

(b) déterminer au moins l'un des paramètres T suivants :

(i) un premier paramètre T ($p_{T1}$) sous la forme du quatrième paramètre SOC ($p_{SOC4}$),
(ii) un deuxième paramètre T ($p_{T2}$) sous la forme du cinquième paramètre SOC (psocs),
(iii) un troisième paramètre T ($p_{T3}$) sous la forme du huitième paramètre SOH ($p_{SOH8}$),
(iv) un quatrième paramètre T ($p_{T4}$) sous la forme du neuvième paramètre SOH (psoHS), et
(v) un cinquième paramètre T ($p_{T5}$) sous la forme d'une fréquence en section méridienne ($f_{As}$),

- pour laquelle la partie imaginaire de l'impédance Z est nulle et
- qui est supérieure à la fréquence de maximum en demi-arc (fHbM),

(c) former un vecteur ligne T $\overrightarrow{P_T}$ à partir des paramètres T et de tous les termes mixtes de la forme $p_{T,m} \cdot p_{T,n}$ , m=1, ..., 5, n=1, ..., m, et

(d) multiplier le vecteur ligne T $\overrightarrow{P_T}$ par un vecteur d'étalonnage stocké $\overrightarrow{A_T}$, de manière à obtenir la température T.

**7.** Procédé selon la revendication 6,
**caractérisé en ce que** l'on détermine tous les paramètres T.

**8.** Procédé selon la revendication 7,
**caractérisé en ce que** le calcul des vecteurs d'étalonnage $\overrightarrow{A_{SOH}}$, $\overrightarrow{A_{SOC}}$ et/ou $\overrightarrow{A_T}$ comprend les étapes suivantes consistant à :

($\alpha$) fournir un accumulateur neuf (12),

($\beta$) mesurer une capacité $K_{SOH,réel}$ à température ambiante de l'accumulateur (12),

(x) ajuster un état de charge SOC à température ambiante, qui est quantifié par le paramètre d'état de charge $K_{SOC,réel}$,

($\delta$) régler une température de l'accumulateur (12), qui est quantifiée par la température $K_T$,

($\epsilon$) déterminer les paramètres SOH $p_{SOH,réel,i}$ (i=1, ...,11), les paramètres SOC $p_{SOC,réel,j}$, j=1, ..., 7 et les paramètres de température $p_{T,k}$ avec k = 1, ..., 5,

($\phi$) répéter les étapes ($\delta$) et ($\epsilon$) avec Q températures avec 4<Q<1000,

($\gamma$) répéter les étapes ($\chi$) à ($\Phi$), avec M états de charge,

($\eta$) faire vieillir les accumulateurs,

(t) répéter (N-1) fois les étapes ($\beta$) à ($\eta$) jusqu'à une capacité prédéterminée, de manière à obtenir $N \cdot M \cdot Q$ valeurs de mesure sous la forme des paramètres SOH $p_{SOH,réel,i}$, des paramètres SOC $p_{SOC,réel,j}$ et des paramètres T $p_{T,k}$ dépendant du vieillissement, de l'état de charge et de la température, avec respectivement un paramètre de vieillissement associé $K_{SOH,réel}$, un paramètre d'état de charge associé $K_{SOC,réel}$ et une température associée $K_{T,réel}$, et

(cp) calculer le vecteur d'étalonnage SOH $\overline{A_{SOH}}$, le vecteur d'étalonnage SOC $\overline{A_{SOC}}$ et le vecteur d'étalonnage T $\overline{A_T}$ à partir des valeurs mesurées.

**9.** Procédé selon la revendication 8,
**caractérisé en ce que** le calcul du vecteur d'étalonnage SOH $\overline{A_{SOH}}$ comprend les étapes suivantes consistant à :

($\alpha$) former un vecteur de valeurs mesurées SOH

$$\overrightarrow{M_{SOH,\text{réel}}} = \begin{pmatrix} K_{SOH,\text{réel}}(1) \\ K_{SOH,\text{réel}}(2) \\ \vdots \\ K_{SOH,\text{réel}}(N \cdot M \cdot Q - 1) \\ K_{SOH,\text{réel}}(N \cdot M \cdot Q) \end{pmatrix}$$

à partir des paramètres de vieillissement $K_{SOH,\text{réel}}$ (r), r=1, ..., $N \cdot M \cdot Q$, dépendants du vieillissement,
(β) former une matrice de paramètres SOH

$$\boldsymbol{P}_{SOH,\text{réel}} = \begin{pmatrix} \vec{P}_{SOH,\text{réel}}(1) \\ \vec{P}_{SOH,\text{réel}}(2) \\ \vdots \\ \vec{P}_{SOH,\text{réel}}(N \cdot M \cdot Q) \end{pmatrix},$$

(χ) dans les lignes desquelles se trouvent les vecteurs lignes $\overline{P}_{SOH,\text{réel}}(r)$, r=1,..., $N \cdot M \cdot Q$, le vecteur ligne $\overline{P}_{SOH,\text{réel}}(r)$ étant formé des paramètres SOH et de tous les termes mixtes de la forme $p_{SOH,\text{réel},m} \cdot p_{SOH,\text{réel},n}$, m=1, ..., 11, n=1, ..., m, et
(δ) calculer le vecteur d'étalonnage SOC $\overline{A_{SOH}}$, qui approche de manière optimale le système d'équations $\overline{M_{SOH,\text{réel}}} = \boldsymbol{P}_{SOH,\text{réel}} \cdot \overline{A_{SOH}}$ en ne conservant que les composantes significatives de $\overline{A_{SOH}}$, les composantes non significatives étant mises à zéro et les composantes significatives de $\overline{A_{SOH}}$ étant déterminées de manière itérative par régression pas à pas.

**10.** Procédé selon la revendication 8, **caractérisé en ce que**
le calcul du vecteur d'étalonnage SOC $\overline{A_{SOC}}$ comprend les étapes suivantes consistant à :

(α) former un vecteur SOC

$$\overrightarrow{M_{SOC,\text{réel}}} = \begin{pmatrix} K_{SOC,\text{réel}}(1) \\ K_{SOC,\text{réel}}(2) \\ \vdots \\ K_{SOC,\text{réel}}(N \cdot M \cdot Q - 1) \\ K_{SOC,\text{réel}}(N \cdot M \cdot Q) \end{pmatrix}$$

à partir des paramètres SOC $K_{SOC,\text{réel}}$ (r), r=1, ..., $N \cdot M \cdot Q$,
(β) former une matrice de paramètres SOC,

$$\boldsymbol{P}_{SOC,\text{réel}} = \begin{pmatrix} \vec{P}_{SOC,\text{réel}}(1) \\ \vec{P}_{SOC,\text{réel}}(2) \\ \vdots \\ \vec{P}_{SOC,\text{réel}}(N \cdot M \cdot Q) \end{pmatrix}$$

dans les lignes desquelles se trouvent les vecteurs lignes $\boldsymbol{P}_{SOC,\text{réel}}(j)$, j=1, ..., $N \cdot M \cdot Q$, le vecteur ligne $\overline{P}_{SOC,\text{réel}}(j)$

étant formé des paramètres SOC et de tous les termes mixtes de la forme $p_{SOC,réel,m} \cdot p_{SOC,réel,n}$,

($\chi$) calculer le vecteur d'étalonnage SOC $\overline{A_{SOC}}$, qui approche de manière optimale le système d'équations $\overline{M_{SOC,réel}} = \boldsymbol{P}_{SOC,réel} \cdot \overline{A_{SOC}}$ en ne conservant que les composantes significatives de $\overline{A_{SOC}}$, les composantes non significatives étant mises à zéro et les composantes significatives de $\overline{A_{SOC}}$ étant déterminées de manière itérative par régression pas à pas.

**11.** Procédé selon la revendication 8, **caractérisé en ce que**
le calcul du vecteur d'étalonnage T $\overline{A_T}$ comprend les étapes suivantes consistant à :

($\alpha$) former un vecteur T

$$\overrightarrow{M_{T,réel}} = \begin{pmatrix} K_{T,réel}(1) \\ K_{T,réel}(2) \\ \vdots \\ K_{T,réel}(N \cdot M \cdot Q - 1) \\ K_{T,réel}(N \cdot M \cdot Q) \end{pmatrix}$$

à partir des températures $K_{T,réel}(r)$, r=1, ..., $N \cdot M \cdot Q$,

($\beta$) former une matrice de paramètres T

$$\boldsymbol{P}_{T,réel} \begin{pmatrix} \vec{P}_{T,réel}(1) \\ \vec{P}_{T,réel}(2) \\ \vdots \\ \vec{P}_{T,réel}(N \cdot M \cdot Q) \end{pmatrix},$$

dans les lignes desquelles se trouvent les vecteurs lignes $\overline{P}_{T,réel}(j)$, j=1, ..., $N \cdot M \cdot Q$, le vecteur ligne $\overline{P_{T,réel}}$ étant formé des paramètres T et de tous les termes mixtes de la forme $p_{T,réel,m} \cdot p_{T,réel,n}$, m=1, ..., 5, n=1, ..., m,

($\chi$) calculer le vecteur d'étalonnage T $\overline{A_T}$ qui approche de manière optimale le système d'équations $\overline{M_T} = \boldsymbol{P}_{T,réel} \cdot \overline{A_T}$ en ne conservant que les composantes significatives de $\overline{A_T}$, les composantes non significatives étant mises à zéro et les composantes significatives de $\overline{A_T}$ étant déterminées de manière itérative par régression pas à pas.

EP 3 722 823 B1

Fig. 1

Fig. 2

**Realteil-Kurve**

Linear-Bereich im Bereich
der Lokalminimum-Frequenz $f_{LM}$

Fig. 3

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20120078552 A1
- US 20130069660 A1
- US 20030184307 A1
- DE 102016201026 A1
- US 10180460 B1
- WO 2015014764 A2